# EUROPEAN PATENT APPLICATION

(11) **EP 2 804 455 A2**
(43) Date of publication of application: **19.11.2014**
(21) Application number: 14166672.7
(22) Date of filing: 30.04.2014
(51) Int. Cl.: H05K 7/20

(54) **Heat sink and display device with heat sink**

(30) Priority: 17.05.2013 JP 2013105520
(71) Applicant: Funai Electric Co., Ltd., Daito-shi, Osaka 574-0013 (JP)
(72) Inventor: Ishibashi, Daisuke, Daito-shi, Osaka 574-0013 (JP); Kobayashi, Masayoshi, Daito-shi, Osaka 574-0013 (JP)
(74) Representative: Global IP Europe Patentanwaltskanzlei

(57) **Abstract**

A heat sink includes a main component, and an attachment component to which a light source is configured to be attached. The attachment component is disposed at one end of the main component such that the heat sink is configured to dissipate heat generated by the light source. A first region of the heat sink defined by the attachment component and the one end of the main component has a surface area per unit of volume that is smaller than that of a second region of the heat sink defined by the other end of the main component.

## Description

### CROSS-REFERENCE TO RELATED APPLICATIONS

This application claims priority to Japanese Patent Application No. 2013-105520 filed on May 17, 2013. The entire disclosure of Japanese Patent Application No. 2013-105520 is hereby incorporated herein by reference.

### BACKGROUND

### Field of the Invention

This invention generally relates to a heat sink. This invention also relates to a display device with a heat sink.

### Background Information

Display devices having a backlight that emits light toward the rear face of a display panel, such as in a liquid crystal television set, are well-known in the art (see Japanese Unexamined Patent Application No. 2007-311461 (Patent Literature 1), for example). The housing of this display device includes a plastic front cabinet provided on the display panel side, and a plastic rear cabinet provided on the backlight side. A rear frame is provided between the front cabinet and the rear cabinet. The backlight has a heat sink, a wiring board attached to the heat sink, and a plurality of LEDs (light emitting diodes) mounted on the wiring board. The heat sink is fastened to the rear frame by screws.

Another type of heat sink is also known in the art (see Japanese Unexamined Patent Application No. 2012-129379 (Patent Literature 2), for example)

### SUMMARY

However, with the heat sink disclosed in Patent Literature 2, for example, the spread-out surface area of the heat sink is increased, or the overall sheet thickness of the heat sink is increased in order to improve the heat dissipation effect in the heat sink. Thus, the heat sink ends up being larger. It has been discovered that a larger heat sink makes it difficult to lay out the internal parts other than the heat sink that are provided to the display device. Furthermore, it has also been discovered that making the heat sink larger requires a corresponding increase in material expense. Therefore, it ends up being linked to higher cost.

One aspect is to provide a heat sink with which heat dissipation effect can be improved without increasing the size. Another aspect is to provide a display device with a heat sink. In view of the state of the known technology, a heat sink is provided that includes a main component, and an attachment component to which a light source is configured to be attached. The attachment component is disposed at one end of the main component such that the heat sink is configured to dissipate heat generated by the light source. A first region of the heat sink defined by the attachment component and the one end of the main component has a surface area per unit of volume that is smaller than that of a second region of the heat sink defined by the other end of the main component.

Also other objects, features, aspects and advantages of the present disclosure will become apparent to those skilled in the art from the following detailed description, which, taken in conjunction with the annexed drawings, discloses embodiments of the heat sink and the display device.

### BRIEF DESCRIPTION OF THE DRAWINGS

Referring now to the attached drawings which form a part of this original disclosure:
FIG. 1 is a front perspective view of a display device in accordance with a first embodiment;
FIG. 2 is a rear perspective view of the display device illustrated in FIG. 1;
FIG. 3 is a rear elevational view of the display device illustrated in FIG. 1;
FIG. 4 is a rear elevational view of the display device illustrated in FIG. 1, illustrating the interior of the display device;
FIG. 5 is a partial cross sectional view of the main components of the display device, taken along A-A line in FIG. 4;
FIG. 6 is a perspective view of a heat sink of the display device;
FIG. 7 is a partial plan view of the heat sink in the region X in FIG. 6;
FIG. 8 is a partial cross sectional view of the heat sink in the region Y in FIG. 6;
FIG. 9 is a partial plan view of a heat sink in accordance with a modified example of the heat sink in accordance with the first embodiment, illustrating the configuration in a region X corresponding to the region X in FIG. 6;
FIG. 10 is a partial cross sectional view of a heat sink in accordance with another modified example of the heat sink in accordance with the first embodiment, illustrating the configuration in a region Y corresponding to the region Y in FIG. 6;
FIG. 11 is a perspective view of a heat sink in accordance with a second embodiment;
FIG. 12 is a partial cross sectional view of the heat sink in the region X in FIG. 11; and
FIG. 13 is a perspective view of a heat sink in accordance with a modified example of the heat sink in accordance with the second embodiment, illustrating the configuration in a region X corresponding to the region X in FIG. 11.

### DETAILED DESCRIPTION OF EMBODIMENTS

Selected embodiments will now be explained with reference to the drawings. It will be apparent to those skilled in the art from this disclosure that the following descriptions of the embodiments are provided for illustration only and not for the purpose of limiting the invention as defined by the appended claims and their equivalents. Specifically, the numerical values, shapes, materials, constituent elements, layout and connection of the constituent elements, and so forth described in the following embodiments are provided all just for illustration only and not for the purpose of limiting the the invention. The invention is merely defined by the appended claims. Of the constituent elements in the following embodiments, those not discussed in an independent claim are not necessarily required, but will be described for understanding of the embodiments.

### FIRST EMBODIMENT

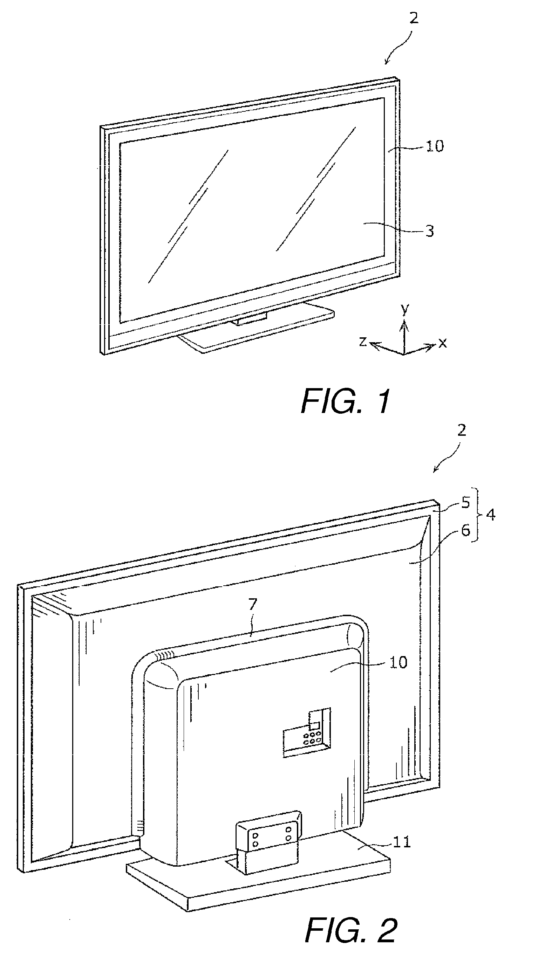

Referring through FIGS. 1 to 8, a display device 2 is illustrated that is equipped with a heat sink 9 in accordance with a first embodiment.

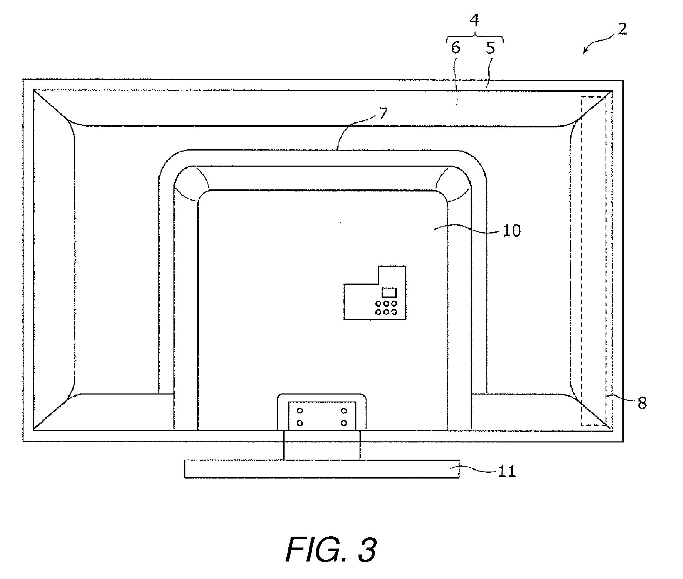

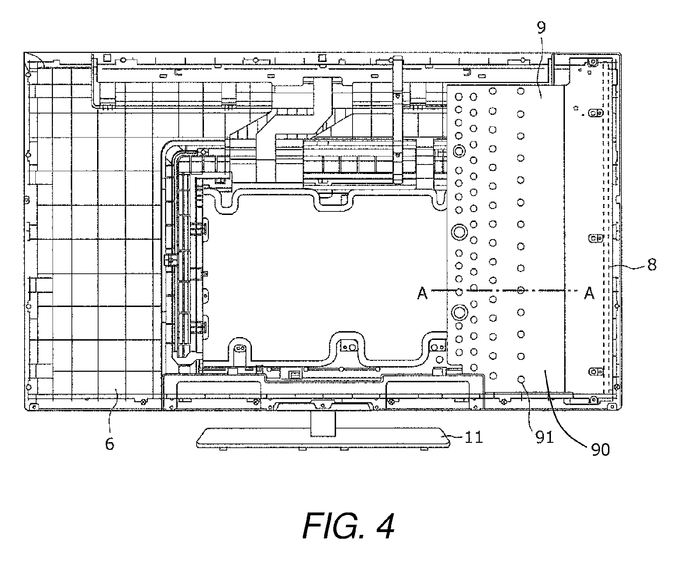

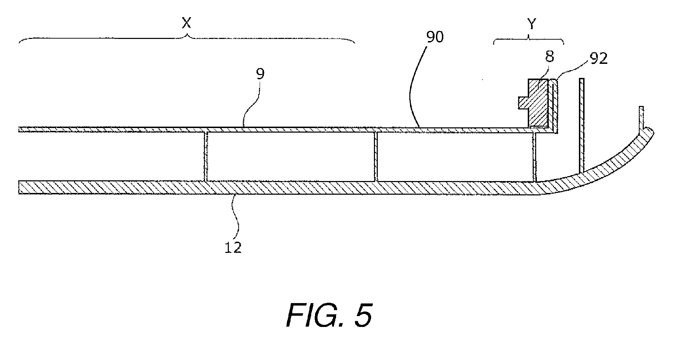

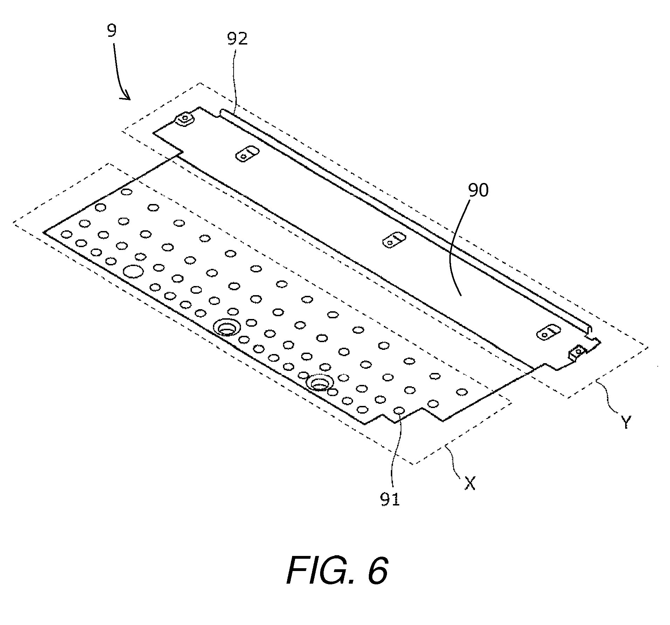

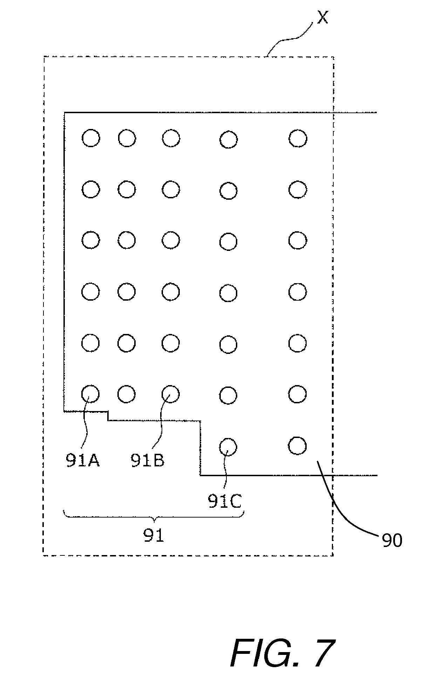

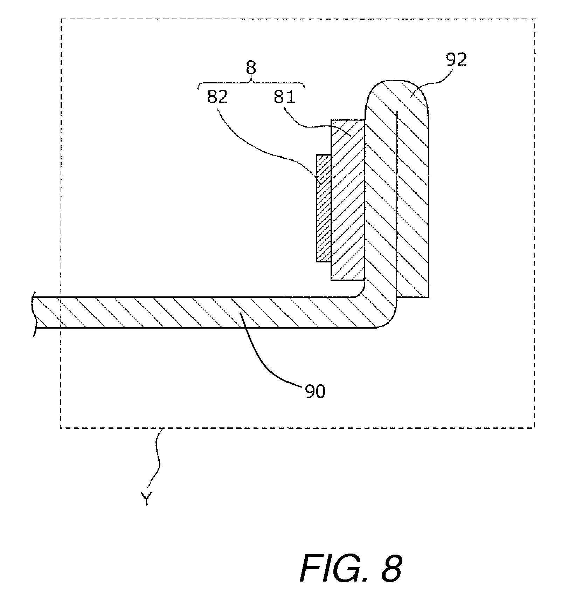

FIG. 1 is a front perspective view of the display device 2 in accordance with the first embodiment. FIG. 2 is a rear perspective view of the display device 2. FIG. 3 is a rear elevational view of the display device 2. FIG. 4 is a rear elevational view of the display device 2, illustrating the interior of the display device 2. FIG. 5 is a partial cross sectional view of the main components of the display device 2, taken along A-A line in FIG. 4. FIG. 6 is a perspective view of the heat sink 9 in accordance with the first embodiment. FIG. 7 is a partial plan view of the heat sink 9 in the region X in FIG. 6. FIG. 8 is a partial cross sectional view of the heat sink 9 in the region Y in FIG. 6.

As shown in FIGS. 1 and 2, the display device 2 is a liquid crystal television set, for example. The display device 2 includes a housing 4 having a front cabinet 5 and a rear frame 6 with a convex component 7, a light source 8, the heat sink 9, a rear cover 10, and a stand 11.

The display panel 3 is disposed inside the housing 4. The light source 8 and the heat sink 9 are also disposed inside the housing 4. The housing 4 is formed by putting together the front cabinet 5 and the rear frame 6.

The front cabinet 5 is disposed on the front side of the display device 2 (i.e., the front side of the display panel 3). As shown in FIG. 1, the front cabinet 5 is in the shape of a picture frame, and covers the outer peripheral part of the display panel 3. The front cabinet 5 here is formed form plastic or another such material.

The display panel 3 is supported by the front cabinet 5 along with a diffusing plate (not shown) and so forth, via a cell guide (not shown). The rear face of the display panel 3 is irradiated with light from the light source 8 (discussed below), causing an image to be displayed on the display panel 3.

The rear frame 6 is formed from plastic or another such material, and is disposed on the rear side of the display device 2 (i.e., the rear side of the display panel 3). As shown in FIG. 2, the rear frame 6 has a shape that bulges out slightly on the rear side of the display device 2 (i.e., the opposite side of the display device 2 from the side with the display panel 3), and covers the entire rear face of the display panel 3.

As shown in FIG. 4, the heat sink 9 is fastened (fixed) via a fastening member to the inner face of the rear frame 6 (i.e., the front side of the display device 2). The "fastening member" here is a screw or hook, for example.

The convex component 7 is provided to the outer face of the rear frame 6. The convex component 7 positions the rear cover 10 (discussed below) with respect to the rear frame 6. As shown in FIG. 3, the convex component 7 extends along the outer peripheral part of the rear cover 10 and protrudes slightly on the opposite side from that of the display panel 3. A power supply board or the like (not shown) for supplying power to the display panel 3, the light source 8 (or a plurality of light sources), etc., is attached to the center part of the rear frame 6. The power supply board or the like is covered by the rear cover 10 when the rear cover 10 is attached to the outer face of the rear frame 6.

The rear cover 10 is formed from plastic or the like, and is attached to the outer face of the rear frame 6. The outer peripheral part of the rear cover 10 contacts with the inner peripheral part of the convex component 7, and is thereby positioning with respect to the rear frame 6.

The stand 11 is attached to the lower end of the rear cover 10, and supports the housing 4 from below.

The light source 8 is an edge-type LED backlight, for example, and is formed in a long, slender shape. The light source 8 shines light on the rear face of the display panel 3 when power is supplied from the above-mentioned power supply board. The light source 8 is attached to the heat sink 9. When the heat sink 9 is fastened to the rear frame 6, the light source 8 is disposed on the right edge of the display device 2 as shown in FIG. 4, for example, and substantially parallel to the right edge.

As shown in FIG. 8, the light source 8 has a board 81 formed in a flat, slender shape, and a plurality of light emitting elements 82. The light emitting elements 82 are disposed on the board 81 in a row, spaced apart in the lengthwise direction of the board 81. The board 81 is formed from a metal with high thermal conductivity, such as aluminum, and is attached to an attachment component 92 of the heat sink 9 (discussed below) by double-sided tape (not shown) having high thermal conductivity.

As shown in FIGS. 4 and 5, the heat sink 9 includes a main component 90 with a plurality of punchings 91, and the attachment component 92 to which the light source 8 is attached, and dissipates the heat generated by the attached light source 8. The attachment component 92 is disposed at one end of the main component 90 such that the heat sink 9 dissipates the heat generated by the light source 8. In the illustrated embodiment, the heat sink has a region Y (e.g., a first region) that is defined by the attachment component 92 and the one end of the main component 90, and a region X (e.g., a second region) that is defined by the other end of the main component 90. More specifically, in the illustrated embodiment, as shown in FIG. 6, the regions X and Y are laterally spaced apart from each other. However, the regions X and Y can be directly adjacent to each other. Also, the region X can be a differently defined as long as the region X includes a part of the main component 90 in which all of the punchings 91 are included. In other words, the region X can range from the other end of the main component 90 to the one end of the main component 90. On the other hand, the region Y can also be a differently defined as long as the region Y includes the attachment component 92. In other words, the region Y can laterally range from the one end of the main component 90 to the location where the nearest point of the punchings 91 closest to the attachment component 92 is located.

More specifically, as shown in FIG. 6, for example, the attachment component 92 is formed at the one end of the heat sink 9 in the region Y. The attachment component 92 is formed thicker (with a higher volume) than the rest portion of the heat sink 9 other than the attachment component 92.

In this embodiment, the attachment component 92 is formed by hemming the one end of the heat sink 9 by stamping. More specifically, as shown in FIG. 8, for example, the attachment component 92 is formed by hemming in which the one end of the heat sink 9 is folded outward (to the right in the drawing) of the heat sink 9. Hemming is a bending method in which a piece of sheet metal is bent at an acute angle and then pushed in further and smashed flat so that it is folded back on itself. Performing the hemming has the effect of doubling the thickness of the folded portion (i.e., increasing the volume). Also, since the hemming can be performed by stamping, the volume of the heat sink 9 in the portion (the region Y) near the light source 8 (heat source) can be easily increased. Specifically, the attachment component 92 has a thickness that is twice as much as that of the rest portion of the heat sink 9 other than the attachment component 92. As shown in FIG. 8, the attachment component 92 extends perpendicularly relative the rest portion of the heat sink 9 other than the attachment component 92. The attachment component 92 has a hemming part formed by stamping the one end of the main component 90. Thus, the attachment component 92 has a thickness that is greater than that of the one end of the main component 90. In the illustrated embodiment, the attachment component 92 has a hemming part formed by outwardly folding the one end of the main component 90 that has been perpendicularly bent relative to the main component 90.

As shown in FIG. 6, for example, in this embodiment, the punchings 91 are formed in the region X that includes the other end of the heat sink 9. Here, the surface area of the heat sink 9 in the region X increases as moving away from the attachment component 92. That is, the pitch of the punchings 91 decreases as moving away from the attachment component 92, as shown in FIG. 7, for example. More specifically, as shown in FIG. 7, the pitch in the direction intersecting the attachment component 92 decreases as moving away from the attachment component 92, in the order of the punchings 91C, the punchings 91B, and the punchings 91A. The result of this configuration is that the heat dissipation of the heat sink 9 increases as moving away from the light source (heat source). Also, since the punchings 91 can be formed by stamping, the surface area of the heat sink 9 in the portion (the region X) farther from the light source 8 (heat source) can be easily increased. In other words, in the illustrated embodiment, the punchings 91 are arranged denser as moving away from the attachment component 92. Thus, the main component 90 includes the punchings 91 in the region X of the heat sink 9. Also, the punchings 91 are spaced apart from each other with the pitch that decreases as moving away from the attachment component 92 (in a lateral direction from the region Y to the region X). Thus, a surface area per unit of volume of the region X of the heat sink 9 increases as moving away from the attachment component 92.

The pitch in the direction along the attachment component 92 can instead decrease as moving away from the attachment component 92, in the order of the punchings 91C, the punchings 91B, and the punchings 91A. The punchings can also be such that the pitch decreases in the directions that intersect and follow the attachment component 92. Doing this allows the surface area of the heat sink 9 to increase moving away from the attachment component 92, so heat generated by the light source 8 can be more efficiently dissipated.

The punchings 91 can also be half-punchings formed by stamping. In other words, the punchings 91 can be recesses or protrusions formed by stamping, instead of through-holes.

As discussed above, the heat sink 9 has the attachment component 92 formed by hemming the one end of the heat sink 9. Thus, the volume of the heat sink 9 in the region X (e.g., the second region) that includes the other end will be less than the volume of the heat sink 9 in the region Y (e.g., the first region) that includes the one end. Also, the heat sink 9 has the punchings 91 formed in the region X. Thus, the surface area of the heat sink 9 in the region X is greater than the surface area of the heat sink 9 in the region Y. In other words, the region Y of the heat sink 9 has a surface area per unit of volume that is smaller than that of the region X of the heat sink 9.

With the heat sink 9 in this embodiment, the thermal capacity of the region Y (e.g., the first region) of the heat sink 9, which is the portion nearer the light source 8 (heat source), is increased. This promotes the absorption of heat generated from the light source 8. This also promotes the dissipation of heat in the region X (e.g., the second region) of the heat sink 9, which is the portion farther away from the light source 8 (heat source). This means that the heat dissipation effect of the heat sink 9 can be enhanced without increasing the size.

Also, because the heat dissipation effect of the heat sink 9 can be enhanced by the above configuration, a given heat dissipation effect can be maintained even if the size of the heat sink 9 is reduced. The effect of this is that the size of the heat sink 9 (the volume of its parts) can be kept to a minimum.

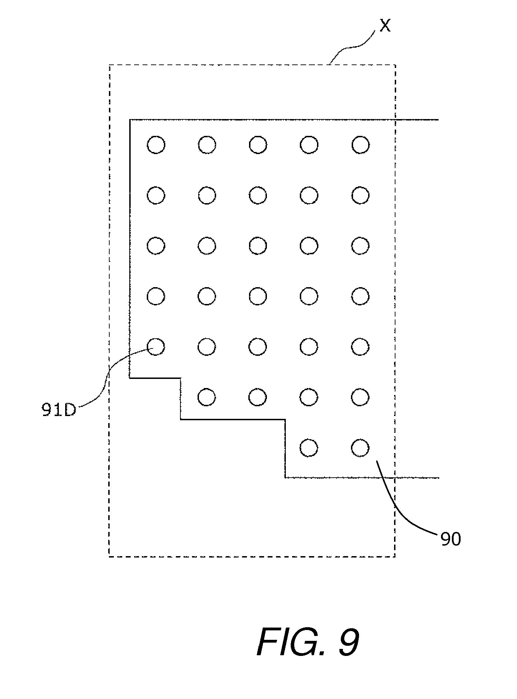

In the illustrated embodiment, as shown in FIG. 7, the pitch of the punchings 91 decreases as moving away from the attachment component 92. However, this is not the only option. FIG. 9 is a partial plan view of a heat sink in accordance with a modified example of the heat sink 9 in a region X corresponding to the region X in FIG. 6. As shown in FIG. 9, the pitch of the punchings 91 can be uniform (constant). This is because even if punchings 91D are formed at a uniform pitch in the region X, the surface area of the heat sink 9 in the region X will be greater than the surface area of the heat sink in the region Y (see FIG. 6). That is, the surface area of the region X can be made greater than the surface area of the region Y, which affords a consistent effect of promoting heat dissipation by the heat sink in the region X, which is the portion farther from the light source 8 (heat source). In other words, the region Y of the heat sink has a surface area per unit of volume that is smaller than that of the region X of the heat sink.

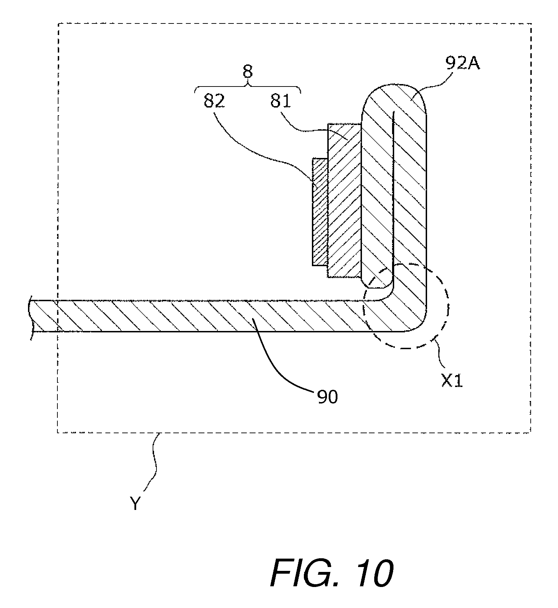

Also, in the illustrated embodiment, the attachment component 92 is formed by hemming in which the one end of the heat sink 9 is folded outward of the heat sink 9. However, this is not the only option. FIG. 10 is a partial cross sectional view of a heat sink in accordance with another modified example of the heat sink 9 in a region Y corresponding to the region Y in FIG. 6. As shown in FIG. 10, an attachment component 92A can be formed by hemming in which one end of the heat sink is folded inward (to the left in the drawing) of the heat sink. In this case, when the attachment component 92A is formed by hemming the one end of the heat sink, a radius is formed at a different sheet portion (e.g., the one end of the heat sink in the region X1 in FIG. 10) from the sheet portion where the light source 8 is attached, out of the two sheet portions forming the attachment component 92A. Thus, the radius does not interfere when the light source 8 is attached to the attachment component 92A. Thus, the attachment component 92A has a hemming part formed by inwardly folding the one end of the main component 90 that has been perpendicularly bent relative to the main component 90.

### SECOND EMBODIMENT

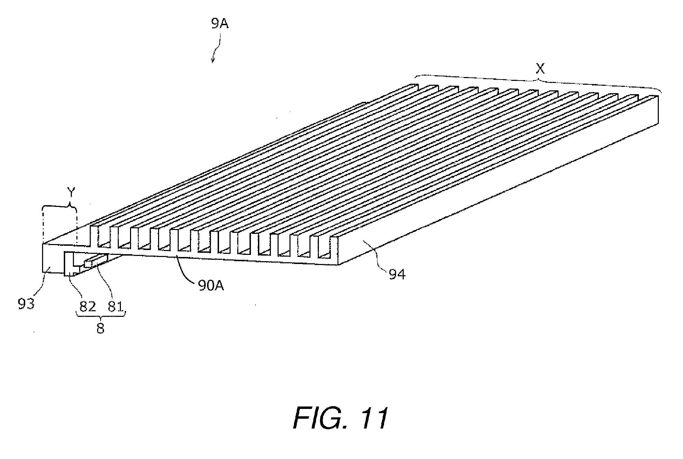

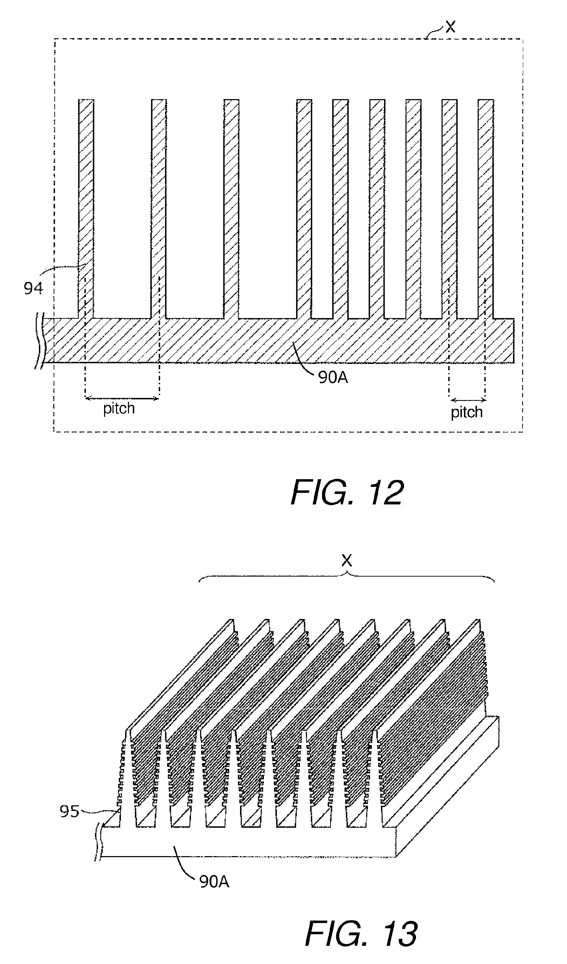

Referring now to FIGS. 11 and 12, a heat sink 9A in accordance with a second embodiment will now be explained. In view of the similarity between the first and second embodiments, the parts of the second embodiment that are identical to the parts of the first embodiment will be given the same reference numerals as the parts of the first embodiment. Moreover, the descriptions of the parts of the second embodiment that are identical to the parts of the first embodiment may be omitted for the sake of brevity.

In the first embodiment, the heat sink 9 includes the attachment component 92 and the punchings 91 formed by stamping. However, this is not the only option. In this embodiment, a different heat sink shape from that in the first embodiment will now be described through reference to the drawings.

FIG. 11 is a perspective view of the heat sink 9A in accordance with the second embodiment. FIG. 12 is a partial cross sectional view of the heat sink 9A in the region X in FIG. 11. Those components that are the same as in FIGS. 5 to 8 are numbered the same and will not be described again in detail.

As shown in FIG. 11, the heat sink 9A differs from the heat sink 9 in accordance with the first embodiment shown in FIG. 6, for example, in the shape of an attachment component 93 and the shape in the region X.

More specifically, as shown in FIG. 11, the heat sink 9A includes a main component 90A with a plurality of fins 94, and the attachment component 93 to which the light source 8 is attached. The attachment component 93 is disposed at one end of the main component 90A such that the heat sink 9A dissipates the heat generated by the attached light source 8. In the illustrated embodiment, the heat sink has a region Y (e.g., a first region) that is defined by the attachment component 93 and the one end of the main component 90A, and a region X (e.g., a second region) that is defined by the other end of the main component 90A. More specifically, in the illustrated embodiment, the regions X and Y can be laterally spaced apart from each other. However, the regions X and Y can also be directly adjacent to each other. Also, the region X can be a differently defined as long as the region X includes a part of the main component 90A in which all of the fins 94 are included. In other words, the region X can range from the other end of the main component 90A to the one end of the main component 90A. On the other hand, the region Y can also be a differently defined as long as the region Y includes the attachment component 93. In other words, the region Y can laterally range from the one end of the main component 90 to the location where the nearest point of the fins 94 closest to the attachment component 93 is located.

More specifically, the attachment component 93 is formed at the one end of the heat sink 9A in the region Y, just as in the first embodiment. Also, the attachment component 93 is formed thicker (with a greater volume) than the rest of the heat sink 9A other than the attachment component 93.

In this embodiment, the attachment component 93 is formed by extrusion molding. Since the attachment component 93 can thus be formed using extrusion molding, the volume of the heat sink 9A can be easily increased in the portion (e.g., the region Y) nearer to the light source 8 (heat source). As shown in FIG. 11, the attachment component 93 extends perpendicularly relative the rest portion of the heat sink 9 other than the attachment component 93. The attachment component 93 has a molding part formed by the extrusion molding. Thus, the attachment component 93 has a thickness that is greater than that of the one end of the main component 90A. The attachment component 93 perpendicularly extends from the one end of the main component 90A with respect to the main component 90A.

Also, the plurality of fins 94 are formed in the region X that includes the other end of the heat sink 9A. The fins 94 are formed by extrusion molding. With this configuration, the fins 94 can be easily formed using extrusion molding, so the surface area of the heat sink 9A can be easily increased in the portion (the region X) farther away from the light source 8 (heat source).

Here, the surface area of the heat sink 9A in the region X increases as moving away from the attachment component 93. Specifically, the pitch of the fins 94 is reduced as moving away from the attachment component 93, as shown in FIG. 12, for example. Since the surface area of the heat sink 9A thus increases as moving away from the attachment component 93, heat generated by the light source 8 can be dissipated more efficiently. Thus, in the illustrated embodiment, the fins 94 are arranged denser as moving away from the attachment component 93. Thus, the main component 90A includes the fins 94 disposed on the region X of the heat sink 9A. Also, the fins 94 are spaced apart from each other with the pitch that decreases as moving away from the attachment component 93 (in a lateral direction from the region Y to the region X). Thus, a surface area per unit of volume of the region X of the heat sink 9A increases as moving away from the attachment component 93.

As discussed above, the heat sink 9A has the attachment component 93 that is formed thicker by extrusion molding. Thus, the volume of the heat sink 9A in the region X (e.g., the second region) that includes the other end can be smaller than the volume of the heat sink 9A in the region Y (e.g., the first region) that includes the one end. Also, the heat sink 9A has the fins 94 formed in the region X. As a result, the surface area of the heat sink 9A in the region X is greater than the surface area of the heat sink 9A in the region Y. In other words, the region Y of the heat sink 9A has a surface area per unit of volume that is smaller than that of the region X of the heat sink 9A.

With the heat sink 9A in this embodiment, the thermal capacity of the region Y (e.g., the first region) of the heat sink 9A, which is the portion nearer the light source 8 (heat source), is increased. This promotes the absorption of heat generated from the light source 8. This also promotes the dissipation of heat in the region X (e.g., the second region) of the heat sink 9A, which is the portion farther away from the light source 8 (heat source). This means that the heat dissipation effect of the heat sink 9A can be enhanced without increasing the size.

Also, because the heat dissipation effect of the heat sink 9A can be enhanced by the above configuration, a given heat dissipation effect can be maintained even if the size of the heat sink 9A is reduced. The effect of this is that the size of the heat sink 9A (the volume of its parts) can be kept to a minimum.

Furthermore, the fins 94 can be formed by the same method (extrusion molding) as the attachment component 93. Thus, the above configuration can be easily formed.

The heat sink 9A is not limited to being produced by the method discussed above. The attachment component 93 of the heat sink 9A can be formed so as to provide a thicker part by using a bulge produced by casting (heading). In this case, the fins 94 should be formed by flattening by casting (heading).

FIG. 13 is a perspective view of a heat sink in accordance with a modified example of the heat sink 9A in a region X corresponding to the region X in FIG. 11.

In the second embodiment, the shape of the fins 94 is rectangular as shown in FIG. 12, for example. However, this is not the only option. For example, as shown in FIG. 13, bumps or protrusions can be formed on triangular fins 95. Forming the fins 95 in this way further increases the surface area of the heat sink in the region X. Consequently, it has the effect of further promoting the dissipation of heat from the heat sink in the region X, which is the portion farther away from the light source 8 (heat source). In other words, the region Y of the heat sink can have a surface area per unit of volume that is smaller than that of the region X of the heat sink.

As discussed above, the present application provides a heat sink with which the heat dissipation effect can be enhanced without an increase in size. Also, the present application provides a display device with this heat sink. More specifically, with the heat sink and the display device with this heat sink, the thermal capacity of the first region of the heat sink is increased in the portion closer to the light source (heat source), which promotes the absorption of heat generated from the light source, and also promotes heat dissipation in the second region of the heat sink in the portion farther away from the light source (heat source). Consequently, a heat sink can be obtained with which the heat dissipation effect can be enhanced without an increase in size.

The heat sink and the display device with this heat sink in accordance with the above-described embodiments are provided for illustration only, not for the purpose of limiting the invention. The above embodiments and modification examples can be variously combined as needed and/or desired.

For instance, the light source 8 described above is an edge-type LED backlight. However, a directly-under type of LED backlight can be used instead.

The present invention can be applied to heat sinks and display devices with the heat sinks. The present invention can also be applied to organic monitors and liquid crystal monitors used for computers, television sets equipped with organic panels, liquid crystal panels, etc., and the like.

The heat sink in accordance with one aspect of the present invention includes the main component, and the attachment component to which the light source is configured to be attached. The attachment component is disposed at one end of the main component such that the heat sink is configured to dissipate heat generated by the light source. The first region of the heat sink defined by the attachment component and the one end of the main component has a surface area per unit of volume that is smaller than that of the second region of the heat sink defined by the other end of the main component.

With this configuration, the thermal capacity of the first region of the heat sink in a portion near the light source (heat source) is increased. This can promote the absorption of heat generated by the light source. This also can promote heat dissipation in the second region of the heat sink in a portion farther away from the light source (heat source). Consequently, a heat sink can be obtained in which the heat dissipation effect is improved without increasing the size.

With this configuration, the heat dissipation effect can be improved. In other words, the heat dissipation effect can be maintained even if the size is reduced. This has the effect of allowing the size of the heat sink (the volume of the parts) to be kept to a minimum.

With the heat sink, the surface area per unit of volume of the second region increases as moving away from the attachment component.

With this configuration, the heat dissipation of the heat sink can be improved in proportion to the distance from the light source (heat source).

With the heat sink, the attachment component can have the hemming part formed by stamping the one end of the main component.

With this configuration, stamping can be used to easily increase the volume of the heat sink in the first region, which is the portion nearer to the light source (heat source).

With the heat sink, the attachment component can have the hemming part formed by inwardly folding the one end of the main component.

With this configuration, even if the attachment component is formed by hemming at the one end of the main component, a radius will be formed at a different sheet portion from the sheet portion where the light source is attached, out of the two sheet portions forming the hemming part. This has the effect that the radius does not interfere when the light source is attached to the attachment component.

With the heat sink, the main component can include a plurality of punchings in the second region of the heat sink.

With this configuration, the surface area of the second region of the heat sink can be easily increased in the portion farther away from the light source (heat source).

With the heat sink, the punchings can be spaced apart from each other with the pitch that decreases as moving away from the attachment component.

With this configuration, the surface area of the heat sink can be increased as moving away from the attachment component. Thus, the heat generated by the light source can be more efficiently dissipated.

With the heat sink, the attachment component can have a molding part formed by extrusion molding.

With this configuration, the attachment component can be formed using extrusion molding. Thus, the volume of the heat sink can be easily increased in the first region in the portion nearer to the light source (heat source).

With the heat sink, the main component can include a plurality of fins disposed on the second region of the heat sink.

With this configuration, the fins can be easily formed using extrusion molding. Thus, the surface area of the heat sink in the second region can be easily increased in the portion farther away from the light source (heat source).

With the heat sink, the fins are spaced apart from each other with the pitch that decreases as moving away from the attachment component.

With this configuration, the surface area of the heat sink can be increased as moving away from the attachment component. Thus, the heat generated by the light source can be more efficiently dissipated.

With the heat sink, the light source can include an edge-type LED backlight.

With the heat sink, the attachment component has a thickness that is greater than that of the one end of the main component.

With the heat sink, the attachment component perpendicularly extends from the one end of the main component with respect to the main component.

The display device in accordance with one aspect of the present invention includes the light source and the heat sink. The light source includes a board and a plurality of light emitting elements disposed on the board. The heat sink includes the main component and the attachment component to which the light source is attached. The attachment component is disposed at one end of the main component such that the heat sink dissipates the heat generated by the light source. The first region of the heat sink defined by the attachment component and the one end of the main component has a surface area per unit of volume that is smaller than that of the second region of the heat sink defined by the other end of the main component.

The present invention provides the heat sink with which the heat dissipation effect can be enhanced even though the size is reduced, as well as the display device with this heat sink.

In understanding the scope of the present invention, the term "comprising" and its derivatives, as used herein, are intended to be open ended terms that specify the presence of the stated features, elements, components, groups, integers, and/or steps, but do not exclude the presence of other unstated features, elements, components, groups, integers and/or steps. The foregoing also applies to words having similar meanings such as the terms, "including", "having" and their derivatives. Also, the terms "part," "section," "portion," "member" or "element" when used in the singular can have the dual meaning of a single part or a plurality of parts unless otherwise stated.

As used herein, the following directional terms "forward", "rearward", "front", "rear", "up", "down", "above", "below", "upward", "downward", "top", "bottom", "side", "vertical", "horizontal", "perpendicular" and "transverse" as well as any other similar directional terms refer to those directions of a display device in an upright position. Accordingly, these directional terms, as utilized to describe the heat sink or the display device should be interpreted relative to a display device in an upright position on a horizontal surface.

Also it will be understood that although the terms "first" and "second" may be used herein to describe various components these components should not be limited by these terms. These terms are only used to distinguish one component from another. Thus, for example, a first component discussed above could be termed a second component and vice-a-versa without departing from the teachings of the present invention. The term "attached" or "attaching", as used herein, encompasses configurations in which an element is directly secured to another element by affixing the element directly to the other element; configurations in which the element is indirectly secured to the other element by affixing the element to the intermediate member(s) which in turn are affixed to the other element; and configurations in which one element is integral with another element, i.e. one element is essentially part of the other element. This definition also applies to words of similar meaning, for example, "joined", "connected", "coupled", "mounted", "bonded", "fixed" and their derivatives. Finally, terms of degree such as "substantially", "about" and "approximately" as used herein mean an amount of deviation of the modified term such that the end result is not significantly changed.

While only selected embodiments have been chosen to illustrate the present invention, it will be apparent to those skilled in the art from this disclosure that various changes and modifications can be made herein without departing from the scope of the invention as defined in the appended claims. For example, unless specifically stated otherwise, the size, shape, location or orientation of the various components can be changed as needed and/or desired so long as the changes do not substantially affect their intended function. Unless specifically stated otherwise, components that are shown directly connected or contacting each other can have intermediate structures disposed between them so long as the changes do not substantially affect their intended function. The functions of one element can be performed by two, and vice versa unless specifically stated otherwise. The structures and functions of one embodiment can be adopted in another embodiment. It is not necessary for all advantages to be present in a particular embodiment at the same time. Every feature which is unique from the prior art, alone or in combination with other features, also should be considered a separate description of further inventions by the applicant, including the structural and/or functional concepts embodied by such feature(s). Thus, the foregoing descriptions of the embodiments according to the present invention are provided for illustration only, and not for the purpose of limiting the invention as defined by the appended claims and their equivalents.

## Claims

1. A heat sink comprising:
a main component; and
an attachment component to which a light source is configured to be attached, the attachment component being disposed at one end of the main component such that the heat sink is configured to dissipate heat generated by the light source,
a first region of the heat sink defined by the attachment component and the one end of the main component having a surface area per unit of volume that is smaller than that of a second region of the heat sink defined by the other end of the main component.

2. The heat sink according to claim 1, wherein
the surface area per unit of volume of the second region increases as moving away from the attachment component.

3. The heat sink according to claim 1 or 2, wherein
the attachment component has a hemming part formed by stamping the one end of the main component.

4. The heat sink according to any one of claims 1 to 3, wherein
the attachment component has a hemming part formed by inwardly folding the one end of the main component.

5. The heat sink according to any one of claims 1 to 4, wherein
the main component includes a plurality of punchings in the second region of the heat sink.

6. The heat sink according to claim 4, wherein
the punchings are spaced apart from each other with a pitch that decreases as moving away from the attachment component.

7. The heat sink according to claim 1 or 2, wherein
the attachment component has a molding part formed by extrusion molding.

8. The heat sink according to claim 7, wherein
the main component includes a plurality of fins disposed on the second region of the heat sink.

9. The heat sink according to claim 8, wherein
the fins are spaced apart from each other with a pitch that decreases as moving away from the attachment component.

10. The heat sink according to any one of of claims 1 to 9, wherein
the light source includes an edge-type LED backlight.

11. The heat sink according to any one of claims 1 to 10, wherein
the attachment component has a thickness that is greater than that of the one end of the main component.

12. The heat sink according to any one of claims 1 to 11, wherein
the attachment component substantially perpendicularly extends from the one end of the main component with respect to the main component.

13. A display device comprising:
a light source including a board and a plurality of light emitting elements disposed on the board; and
a heat sink according to any one of claims 1 to 12.
